# EUROPEAN PATENT APPLICATION

(11) **EP 4 586 310 A1**
(43) Date of publication of application: **16.07.2025**
(21) Application number: 23863103.0
(22) Date of filing: 31.08.2023
(51) Int. Cl.: H01L 23/12, B65H 41/00, H05K 3/46

(54) **CIRCUIT BOARD MANUFACTURING METHOD**

(30) Priority: 05.09.2022 JP 2022140984
(71) Applicant: Mitsui Mining & Smelting Co., Ltd., Shinagawa-ku Tokyo 141-8584 (JP)
(72) Inventor: KOMIYA Mikiko, Ageo-shi, Saitama 362-0021 (JP); NAKAMURA Toshimi, Ageo-shi, Saitama 362-0021 (JP); KITABATAKE Yukiko, Ageo-shi, Saitama 362-0021 (JP); MATSUURA Yoshinori, Ageo-shi, Saitama 362-0021 (JP)
(74) Representative: Potter Clarkson
(86) International application number: PCT/JP2023/031958
(87) International publication number: WO 2024/053565

(57) **Abstract**

Provided is a method for manufacturing a wiring substrate that can easily and reliably release a carrier. The method for manufacturing a wiring substrate includes: providing a laminated sheet that includes a release layer and a wiring layer in order on a carrier; forming a step or gap between the wiring layer and the carrier as a release starting portion; inserting a rigid plate having a long portion to the release starting portion from the long portion, wherein the long portion is longer than a width of the laminated sheet; and moving the rigid plate from the release starting portion along the release layer, thereby developing release of the wiring layer from the carrier, wherein the wiring layer has a flexural modulus at 25°C measured in accordance with JIS K6911-1995 of 0.3 GPa or more and 300 GPa or less.

## Description

### TECHNICAL FIELD

The present invention relates to a method for manufacturing a wiring substrate.

### BACKGROUND ART

In recent years, multilayering of printed wiring boards has become widespread to increase the mounting density of the printed wiring boards for size reduction. Such multilayer printed wiring boards have been in use in many portable electronic apparatuses to reduce weight and size. These multilayer printed wiring boards have been required to have further reductions in the thicknesses of interlayer insulating layers and to still further weight reductions as wiring boards.

As a technique for satisfying such requirements, a method for manufacturing a multilayer printed wiring board using a coreless build-up method has been adopted. The coreless build-up method is a method of alternately laminating (building up) insulating layers and wiring layers for multilayering, without using a so-called core substrate. For the coreless build-up method, using a carrier-attached metal foil has been proposed to enable easy release of a support and a multilayer printed wiring board from each other. For example, Patent Literature 1 (JP2005-101137A) discloses a method for manufacturing a package substrate for semiconductor device mounting, the method including affixing an insulating resin layer to the carrier surface of a carrier-attached copper foil to form a support, forming a first wiring conductor on the superthin copper layer side of the carrier-attached copper foil by steps such as photoresist processing, pattern electrolytic copper plating, and resist removal, then forming build-up wiring layers, releasing the carrier-attached supporting substrate, and removing the superthin copper layer.

For the fining of an embedded circuit as shown in Patent Literature 1, a carrier-attached metal foil in which the thickness of a metal layer is 1 µm or less is desired. Therefore, it has been proposed to use a vapor phase method, such as sputtering, to form a metal layer and achieve a reduction in the thickness of the metal layer. For example, Patent Literature 2 (WO2017/150283) discloses a carrier-attached copper foil in which a release layer, an antireflection layer, and a superthin copper layer (for example, a film thickness of 300 nm) are formed on a carrier such as a glass sheet by sputtering. Patent Literature 3 (WO2017/150284) discloses a carrier-attached copper foil in which intermediate layers (for example, an adhesion metal layer and a release-assisting layer), a release layer, and a superthin copper layer (for example, a film thickness of 300 nm) are formed on a carrier such as a glass sheet by sputtering. Patent Literatures 2 and 3 also teach that intermediate layers composed of predetermined metals are interposed, thus providing excellent stability of the mechanical release strength of the carrier, and that the antireflection layer exhibits a desirable dark color, thus improving visibility in image inspection (for example, automatic image inspection (AOI)).

Especially, with still further size reduction and power saving of electronic devices, there is a growing need for the high integration and thinning of semiconductor chips and printed wiring boards. As next-generation packaging techniques for satisfying such a need, the adoption of fan-out wafer level packaging (FO-WLP) and panel level packaging (PLP) has been studied in recent years. The adoption of the coreless build-up method has also been studied for FO-WLP and PLP. One such method is a method referred to as a redistribution layer-first (RDL-first) method in which a wiring layer and, if necessary, a build-up wiring layer are formed on a coreless support surface, then chips are mounted and sealed, and subsequently the support is released. For example, Patent Literature 4 (JP2015-35551A) discloses a method for manufacturing a semiconductor apparatus, the method including forming a metal release layer on the main surface of a support composed of glass or a silicon wafer, forming an insulating resin layer on the metal release layer, forming a redistribution layer including build-up layers on the insulating resin layer, mounting and sealing semiconductor integrated circuits on the redistribution layer, exposing the release layer by the removal of the support, exposing secondary mounting pads by the removal of the release layer, and forming solder bumps on the surfaces of the secondary mounting pads, and performing secondary mounting.

Meanwhile, when a carrier is released from a wiring layer-attached carrier prepared using a method such as the coreless build-up method, the wiring layer may bend greatly to cause disconnection and peeling off, resulting in a decrease in the connection reliability of the wiring layer. Accordingly, methods for removing a carrier that address such a problem have been proposed. For example, Patent Literature 5 (WO2017/075151) discloses a method for processing a first substrate bonded to a second substrate, in which a wire is moved along the interface to propagate the release front edge and release the first substrate from the second substrate. In the method disclosed in Patent Literature 5, a thin flexible wire is used to reduce bending of the first substrate during the release. When bending of the first substrate during the release is reduced, relatively less bending stress is applied to the first substrate during the release process. Furthermore, the flexibility of the wire is said to allow the wire to conform to the release front edge and release the stress that may grow due to interaction with the shape changes that may occur due to scratches in the glass.

Also, Patent Literature 6 (JP2015-145306A) discloses a method for manufacturing an electronic device in which the release step includes a step of inserting a knife into the interface between a first substrate and a second substrate by a predetermined amount from an end face of the laminate to create a release initiating portion at the interface, and a step of sequentially releasing the interface from the release initiating portion along the release progression direction from one end side to the other end side of the laminate. Patent Literature 6 also discloses that the release initiating portion creating step is characterized by supplying an inclusion such as liquid to the knife and inserting the knife with the attached inclusion to the interface. According to such a method, even if the knife is pulled out from the interface between the first substrate and the second substrate, the liquid that has infiltrated into the interface is said to be able to reliably create the release initiating portion.

### CITATION LIST

### PATENT LITERATURE

Patent Literature 1: JP2005-101137A
Patent Literature 2: WO2017/150283
Patent Literature 3: WO2017/150284
Patent Literature 4: JP2015-35551A
Patent Literature 5: WO2017/075151
Patent Literature 6: JP2015-145306A

### SUMMARY OF INVENTION

However, in the method disclosed in Patent Literature 5, there were cases in which the strength of the wire used was not sufficient, causing rupture, when developing the gap formed by the release, and the release step was interrupted. There was also a problem that when the substrate (for example, resin-containing wiring layer) had a high flexural modulus, the substrate was destroyed or cracked in the release step. Meanwhile, in the method disclosed in Patent Literature 6, a knife to which a chemical solution or the like was attached was used to develop the release, and therefore, there were cases in which the chemical solution was attached to and reacted with the metal constituting the substrate, interfering with the metal etching performed in the subsequent step. As described above, there is room for improvement in conventional methods from the viewpoint of easy and reliable release of the carrier.

The present inventors have now found that a wiring substrate can be manufactured by forming, in a laminated sheet including a carrier, a release layer, and a wiring layer with a predetermined flexural modulus in order, a release starting portion between the wiring layer and the carrier, inserting a predetermined rigid plate into the release starting portion, and then moving the rigid plate along the release layer, thus easily and reliably releasing the carrier.

Therefore, an object of the present invention is to provide a method for manufacturing a wiring substrate that can easily and reliably release a carrier.

The present invention provides the following aspects:

### [Aspect 1]

A method for manufacturing a wiring substrate, comprising the steps of:
providing a laminated sheet that includes a release layer and a wiring layer in order on a carrier;
forming a step or gap between the wiring layer and the carrier as a release starting portion;
inserting a rigid plate having a long portion into the release starting portion from the long portion, wherein the long portion is longer than a width of the laminated sheet; and
moving the rigid plate from the release starting portion along the release layer, thereby developing release of the wiring layer from the carrier,
wherein the wiring layer has a flexural modulus at 25°C measured in accordance with JIS K6911-1995 of 0.3 GPa or more and 300 GPa or less.

### [Aspect 2]

The method for manufacturing the wiring substrate according to aspect 1, wherein the wiring layer has a flexural strength at 25°C measured in accordance with JIS K6911-1995 of 5 MPa or more and 1000 MPa or less.

### [Aspect 3]

The method for manufacturing the wiring substrate according to aspect 1 or 2, wherein the rigid plate has a Rockwell hardness at 25°C measured in accordance with JIS Z2245:2016 of R135 or less.

### [Aspect 4]

The method for manufacturing the wiring substrate according to any one of aspects 1 to 3, wherein the rigid plate has a rupture strength at 25°C measured in accordance with JIS K7161-1:2014 of 0.50 kgf or more.

### [Aspect 5]

The method for manufacturing the wiring substrate according to any one of aspects 1 to 4, wherein a release strength when releasing the wiring layer from the carrier is 0.10 gf/cm or more and 50 gf/cm or less.

### [Aspect 6]

The method for manufacturing the wiring substrate according to any one of aspects 1 to 5, wherein the release starting portion is formed at an end portion of the wiring layer and/or at an end portion of the carrier.

### [Aspect 7]

The method for manufacturing the wiring substrate according to any one of aspects 1 to 6, wherein an insertion angle of the rigid plate with respect to a main surface of the carrier is 0° or more and 90° or less.

### [Aspect 8]

The method for manufacturing the wiring substrate according to any one of aspects 1 to 7, wherein the rigid plate has a tip angle of 0° or more and 90° or less on a long portion side or has a curvature of a tip of 0.1 mm or more and 10 mm or less on a long portion side, when seen in a cross-sectional view.

### [Aspect 9]

The method for manufacturing the wiring substrate according to any one of aspects 1 to 8, wherein a total angle of an insertion angle of the rigid plate with respect to a main surface of the carrier and a tip angle on a long portion side of the rigid plate when the rigid plate is seen in a cross-sectional view is 0° or more and 120° or less.

### [Aspect 10]

The method for manufacturing the wiring substrate according to any one of aspects 1 to 9, wherein the rigid plate has a width of 1.0 mm or more and 300 mm or less.

### [Aspect 11]

The method for manufacturing the wiring substrate according to any one of aspects 1 to 10, wherein the rigid plate has a thickness of 0.040 mm or more and 10 mm or less.

### [Aspect 12]

The method for manufacturing the wiring substrate according to any one of aspects 1 to 11, wherein the rigid plate is composed of a resin.

### [Aspect 13]

The method for manufacturing the wiring substrate according to any one of aspects 1 to 12, wherein the step of forming the release starting portion and/or the step of developing release is performed without attaching any liquid to the step or gap.

### [Aspect 14]

The method for manufacturing the wiring substrate according to any one of aspects 1 to 13, wherein the wiring layer includes at least one selected from the group consisting of a metal layer, a semiconductor device, and a resin-containing layer.

### [Aspect 15]

The method for manufacturing the wiring substrate according to any one of aspects 1 to 14, wherein the wiring layer has a thickness of 0.1 µm or more and 5.0 mm or less.

### [Aspect 16]

The method for manufacturing the wiring substrate according to any one of aspects 1 to 15, wherein the wiring layer includes a metal layer and a resin-containing layer.

### [Aspect 17]

The method for manufacturing the wiring substrate according to any one of aspects 1 to 15, wherein the wiring layer includes a resin-containing layer, and the resin-containing layer includes a filler.

### [Aspect 18]

The method for manufacturing the wiring substrate according to any one of aspects 14 to 17, wherein the resin-containing layer has a filler content of 95% by weight or less.

### BRIEF DESCRIPTION OF DRAWINGS

Figure 1 is a schematic cross-sectional view showing an example of a laminated sheet used in the present invention.
Figure 2A is a process flow chart showing in a schematic top view an example of a method for manufacturing the wiring substrate according to the present invention, and corresponds to the initial step (steps (i) and (ii)).
Figure 2B is a process flow chart showing steps corresponding to Figure 2A in a schematic cross-sectional view.
Figure 3A is a process flow chart showing in a schematic top view an example of a method for manufacturing the wiring substrate according to the present invention, and corresponds to the later step (steps (iii) to (v)) following the step shown in Figure 2A.
Figure 3B is a process flow chart showing steps corresponding to Figure 3A in a schematic cross-sectional view.
Figure 4 is a schematic cross-sectional view for describing the tip angle θ of a rigid plate.
Figure 5 is a schematic cross-sectional view showing an example of a conventional method for releasing a carrier, using a wire.
Figure 6 is a photograph in which an intermediate layer (copper layer) and a metal layer (titanium layer) after the carrier release are taken in the laminated sheet made in Example 1.
Figure 7 is a photograph in which an intermediate layer (copper layer) and a metal layer (titanium layer) after the carrier release are taken in the laminated sheet made in Example 2 (comparative).

### DESCRIPTION OF EMBODIMENTS

### Method for Manufacturing wiring substrate

The present invention relates to a method for manufacturing a wiring substrate. The method of the present invention comprises the steps of: (1) provision of a laminated sheet, (2) formation of a release starting portion, (3) insertion of a rigid plate, (4) movement of the rigid plate, and (5) release of a carrier, optionally performed.

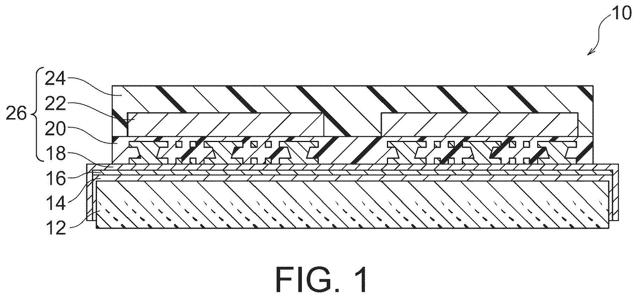

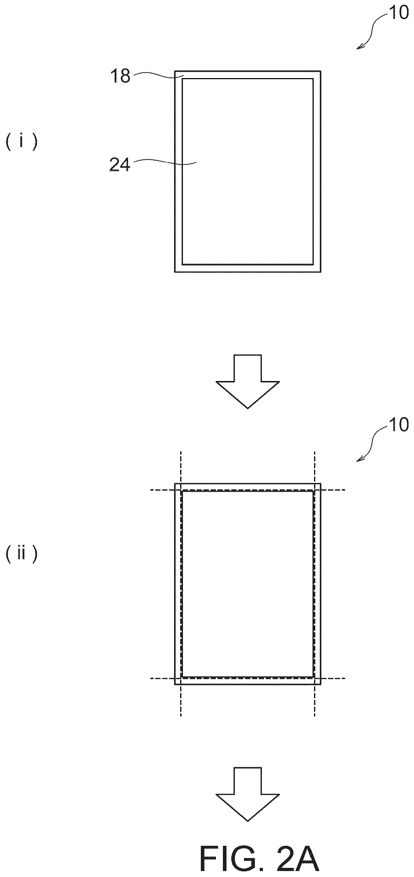

Figure 1 shows an example of the laminated sheet used in the present invention, and Figures 2A to 3B show an example of the method for manufacturing the wiring substrate of the present invention. Each of the steps (1) to (5) will be described below with reference to the drawings.

### (1) Provision of Laminated Sheet

As shown in Figures 1, 2A(i), and 2B(i), a laminated sheet 10 is provided including a release layer 16 and a wiring layer 26 in order on a carrier 12. The release layer 16 is a layer that is provided on the carrier 12 and contributes to the release of the carrier 12 and the wiring layer 26 from each other. The wiring layer 26 is a layer including a wiring conductor provided on the release layer 16.

The laminated sheet 10 may further include an intermediate layer 14 between the carrier 12 and the release layer 16. Each of the intermediate layer 14, the release layer 16, and the wiring layer 26 may be a single layer composed of one layer or a multilayer composed of two or more layers.

The laminated sheet 10 can be provided, for example, in the following manner. First, a carrier-attached metal foil is provided including the intermediate layer 14, the release layer 16, and a metal layer 18 on the carrier 12. Then, a first wiring layer is formed on the surface of the metal layer 18. Thereafter, a redistribution layer 20 is constructed on the basis of the first wiring layer. The formation of the first wiring layer and the construction of the redistribution layer 20 should be carried out by a known method, and for example, the coreless build-up method described above can be preferably adopted. If necessary, a semiconductor device 22 may be mounted on the first wiring layer (or on the redistribution layer 20 constructed on the basis of the first wiring layer) (see Figure 1). When the electrode of the semiconductor device 22 is bonded to the wiring of the redistribution layer 20, the semiconductor device 22 is electrically connected to the redistribution layer 20. The semiconductor device 22 is preferably covered with a resin-containing layer 24 after being mounted on the redistribution layer 20. The "wiring layer" as used herein is defined as encompassing not only the redistribution layer 20 (which can also be referred to as wiring layer in the narrow sense), but also the metal layer 18, the semiconductor device 22, and the resin-containing layer 24, and can also be referred to as "device layer". As used herein, the carrier 12, the intermediate layer 14 (when present), the release layer 16, and the metal layer 18 may be collectively referred to as "carrier-attached metal foil". A preferred aspect of the carrier-attached metal foil will be described later.

As described above, the wiring layer 26 may include at least one selected from the group consisting of the metal layer 18, the semiconductor device 22, and the resin-containing layer 24. The wiring layer 26 preferably includes at least the resin-containing layer 24, and more preferably includes the metal layer 18 and the resin-containing layer 24.

The flexural modulus of the wiring layer 26 is 0.3 GPa or more and 300 GPa or less, preferably 0.7 GPa or more and 200 GPa or less, more preferably 1.0 GPa or more and 100 GPa or less, further preferably 1.5 GPa or more and 70 GPa or less, and particularly preferably 2.0 GPa or more and 28 GPa or less. Also, the flexural strength of the wiring layer 26 is preferably 5 MPa or more and 1000 MPa or less, more preferably 8 MPa or more and 700 MPa or less, further preferably 15 MPa or more and 500 MPa or less, particularly preferably 25 MPa or more and 350 MPa or less, and most preferably 70 MPa or more and 200 MPa or less. The flexural modulus and flexural strength as used herein are values measured under conditions of 25°C in accordance with JIS K6911-1995. In this way, even if the wiring layer 26 has a high flexural modulus and/or flexural strength, in other words, even if it is a hard and brittle device, the method of the present invention can perform release of the carrier 12 while effectively suppressing damage or destruction of the wiring layer 26. When the wiring layer 26 includes the resin-containing layer 24, at least the flexural modulus and/or flexural strength of the resin-containing layer 24 should be within the above range.

The thickness of the wiring layer 26 is preferably 0.1 µm or more and 5.0 mm or less, more preferably 0.1 µm or more and 3.0 mm or less, further preferably 0.4 µm or more and 2.0 mm or less, and particularly preferably 0.8 µm or more and 1.0 mm or less. When the wiring layer 26 includes the resin-containing layer 24, the thickness of the resin-containing layer 24 is preferably 2.0 mm or less, more preferably 5 µm or more and 1.0 mm or less, further preferably 8 µm or more and 500 µm or less, and particularly preferably 15 µm or more and 350 µm or less. In this way, even if the wiring layer 26 is thin, the method of the present invention can perform release of the carrier 12 while effectively suppressing damage or destruction of the wiring layer 26 (in particular, resin-containing layer 24).

The resin-containing layer 24 is a layer that contains a resin, and is typically a layer (mold layer) for sealing and protecting a semiconductor device (chip). Preferred examples of the resin constituting the resin-containing layer 24 include epoxy resins and resins containing epoxy resins. The resin-containing layer 24 preferably includes a filler from the viewpoint of improving flexural modulus and/or flexural strength. Preferred examples of the filler include silica and titania. The content of the filler in the resin-containing layer 24 is preferably 0% by weight or more and 95% by weight or less, more preferably 50% by weight or more and 93% by weight or less, and further preferably 82% by weight or more and 91% by weight or less. The average particle size D50 of the filler is preferably 1.0 µm or more and 70 µm or less, and more preferably 10 µm or more and 25 µm or less. As used herein, the average particle size D50 shall mean the particle size at which the integrated volume from the smaller particle size side reaches 50% in the particle size distribution obtained by the laser diffraction scattering method.

### (2) Formation of Release Starting Portion

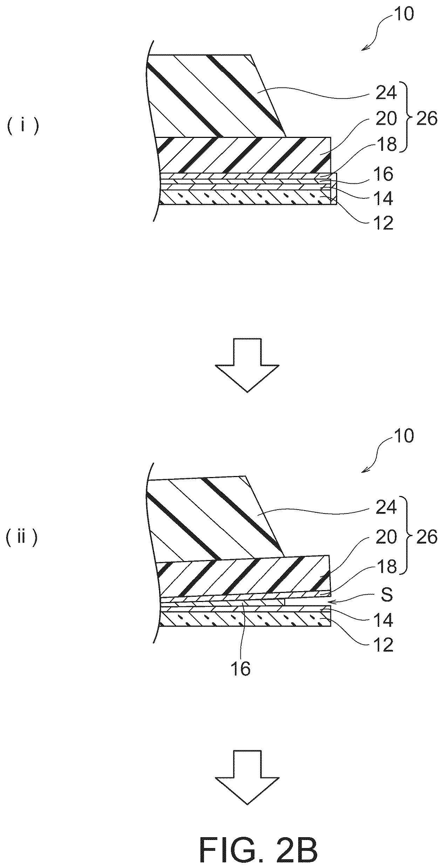

A step or gap is formed between the wiring layer 26 and the carrier 12 as a release starting portion S (see Figure 2B(ii)). Using this release starting portion S as a trigger, release of the carrier 12 can be smoothly performed by inserting and moving a rigid plate, as described below. Note that the cross-section of the resin-containing layer 24 is trapezoidal in Figures 2B(i) and (ii), but it may also be rectangular or oblong in shape.

The release starting portion S is preferably formed at an end portion of the wiring layer 26 and/or at an end portion of the carrier 12 from the viewpoint of facilitating the insertion of the rigid plate. Also, when the laminated sheet 10 is polygonal in shape (for example, rectangular), the release starting portion S is more preferably formed at a corner part of the wiring layer 26 and/or at a corner part of the carrier 12.

The method for forming the release starting portion S is not particularly limited, and any method may be used. For example, the release starting portion S can be formed by partially releasing an area including an end portion of the release layer 16 by inserting a thin piece between the wiring layer 26 and the carrier 12 (near the release layer 16), by applying force to an end portion of the laminated sheet 10 in a direction where the wiring layer 26 and the carrier 12 are separated, or by other means.

Meanwhile, when an end portion of the release layer 16 is covered with the metal layer 18 as shown in Figure 1, it can be difficult to form the release starting portion S. In this case, it is preferable to expose the end portions of the release layer 16 by trimming the perimeter of the laminated sheet 10 as shown in Figure 2A(ii). Specifically, it is preferable to make a cut from the face of the laminated sheet 10 opposite to the carrier 12 so that the metal layer 18, the release layer 16, and the intermediate layer 14 (when present) are penetrated when the laminated sheet 10 is seen in a cross-sectional view. By removing the sections in the metal layer 18 that cover the end portions of the release layer 16 in this manner, the end faces of the release layer 16 can be exposed.

The formation of the release starting portion S can be performed without attaching any liquid (for example, chemical solution such as lubricant) to the step or gap at all. By doing so, defects caused by attachment of liquid to the metallic part of the wiring layer 26 and fluctuation of the etching rate in the attached part can be prevented. That is, it is possible to suppress the occurrence of parts with insufficient etching, the longer time required to perform predetermined etching, and the occurrence of uneven etching caused by the mixing of such areas.

### (3) Insertion of Rigid Plate

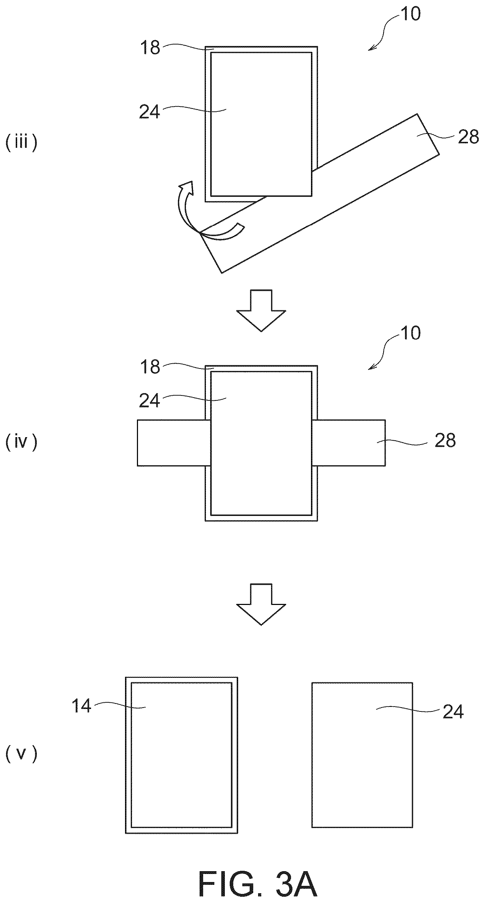

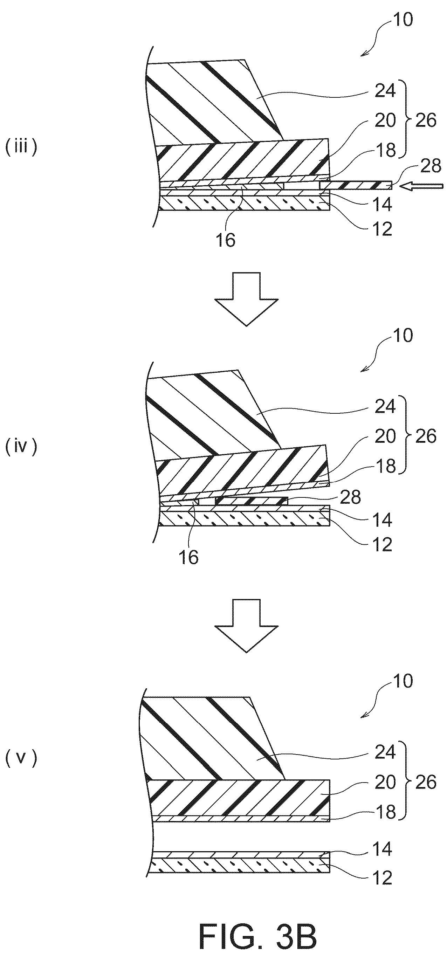

To the formed release starting portion S, a rigid plate 28 having a long portion is inserted from the long portion (see Figure 3A(iii) and Figure 3B(iii)). The rigid plate 28 is a plate with the desired rigidity, and may be in the form of a film or sheet. Here, at least the long portion of the rigid plate 28 is longer than the width of the laminated sheet 10. This allows the rigid plate 28 to be moved as described below while gripping near both ends of the long portion in the rigid plate 28. As a result, it is easier to apply uniform force to the wiring layer 26 without the rigid plate 28 warping, and the release of the carrier 12 can be performed efficiently. When the laminated sheet 10 is rectangular in shape, the long portion of the rigid plate 28 is only required to be longer than the length of the short side of the laminated sheet 10, and may include the long side or may include the short side. On the other hand, when the laminated sheet 10 is disc-shaped, the length of the long portion of the rigid plate 28 is preferably larger than the diameter of the laminated sheet 10. In any case, the length of the long portion of the rigid plate 28 may be changed as appropriate depending on the size of the laminated sheet 10.

The insertion angle of the rigid plate 28 with respect to the main surface of the carrier 12 is preferably 0° or more and 90° or less, more preferably more than 0° and 65° or less, further preferably 3° or more and 30° or less, and particularly preferably 5° or more and 15° or less. This makes it easier to apply force to the wiring layer 26 at the desired release angle and to develop the release of the wiring layer 26 from the carrier 12 when the rigid plate 28 is inserted into the laminated sheet 10 and moved. When the laminated sheet 10 is seen in a cross-sectional view, this insertion angle is defined as, at a location where the tip of the rigid plate 28 (or an imaginary line passing through the tip) is in contact with the surface of the carrier 12 (surface of the intermediate layer 14 when present), an angle formed by the tip of the rigid plate 28 and the surface of the carrier 12.

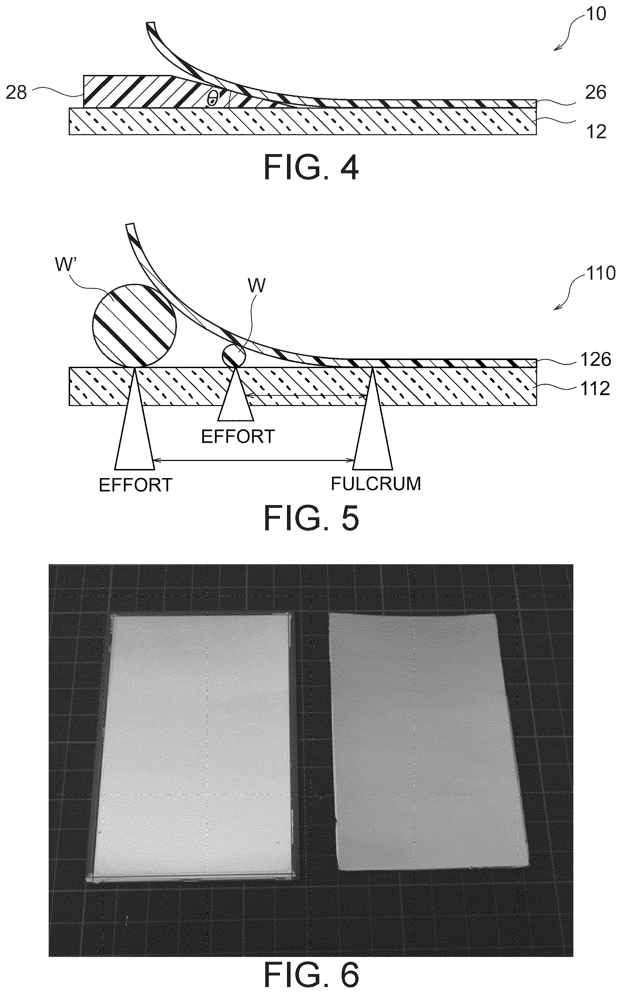

For the rigid plate 28, as shown in Figure 4, the tip angle θ on the long portion side (side in contact with the wiring layer 26) when seen in a cross-sectional view is preferably 0° or more and 90° or less, more preferably more than 0° and 45° or less, and further preferably more than 5° and 45° or less. Also, the total angle of the insertion angle of the rigid plate 28 and the tip angle of the rigid plate 28 is preferably 0° or more and 120° or less, more preferably more than 0° and 90° or less, and most preferably more than 5° and 45° or less. Alternatively, the tip of the rigid plate 28 on the long portion side (side in contact with the wiring layer 26) may have a curvature of 0.1 mm or more and 10 mm or less, and more preferably has a curvature of 0.2 mm or more and 10 mm or less, and further preferably of 0.5 mm or more and 5.0 mm or less. This makes it even further easier to develop the release of the wiring layer 26 from the carrier 12 and also makes it possible to more effectively suppress damage of the wiring layer 26 when the rigid plate 28 comes into contact with the wiring layer 26.

The Rockwell hardness of the rigid plate 28 at 25°C measured in accordance with JIS Z2245:2016 is preferably R135 or less, more preferably R132 or less, further preferably R130 or less, and particularly preferably R128 or less. The lower limit of Rockwell hardness is not particularly limited, but is typically R50 or more. By making it such a soft material, it is more difficult for the rigid plate 28 to scratch the wiring layer 26 when inserted into the laminated sheet 10 and moved, and the damage of the wiring layer 26 caused by contact with the rigid plate 28 can be more effectively suppressed when the release of the wiring layer 26 from the carrier 12 is developed.

The rupture strength of the rigid plate 28 at 25°C measured in accordance with JIS K7161-1:2014 is preferably 0.50 kgf or more, more preferably 0.80 kgf or more, further preferably 2.0 kgf or more, and particularly preferably 4.0 kgf or more. The upper limit of rupture strength is not particularly limited, but is typically 10 kgf or less. By making it a material with such strength, rupture of the rigid plate 28 can be suppressed even when the rigid plate 28 is inserted into the laminated sheet 10 and moved to develop the release of the wiring layer 26 from the carrier 12, effectively preventing the step from being interrupted.

The release strength when releasing the wiring layer 26 from the carrier 12 is preferably 0.10 gf/cm or more and 50 gf/cm or less, more preferably 1.0 gf/cm or more and 30 gf/cm or less, further preferably 1.5 gf/cm or more and 10 gf/cm or less, and particularly preferably 2.0 gf/cm or more and 5.0 gf/cm or less. By using a material with such release strength, even when the rigid plate 28 is inserted into the laminated sheet 10 and moved to develop the release of the wiring layer 26 from the carrier 12, the release of the wiring layer 26 from the carrier 12 can be easily developed, and also the damage of the wiring layer 26 caused by contact with the rigid plate 28 can be more effectively suppressed, and furthermore, rupture of the rigid plate 28 can be prevented, effectively preventing the step from being interrupted.

The flexural modulus of the rigid plate 28 is preferably 0.1 GPa or more and 20 GPa or less, more preferably 0.3 GPa or more and 10 GPa or less, further preferably 0.5 GPa or more and 7.0 GPa or less, and particularly preferably 1.0 GPa or more and 5.0 GPa or less. By making the rigid plate 28 a material with such flexural modulus, damage, such as destruction or rupture, of the wiring layer 26 can be more effectively suppressed even when the rigid plate 28 is inserted into the laminated sheet 10 and moved to develop the release of the wiring layer 26 from the carrier 12, effectively preventing a decrease in yield rate and interruption of the step.

The width (short side length) of the rigid plate 28 is preferably 1.0 mm or more and 300 mm or less, more preferably 2.0 mm or more and 100 mm or less, further preferably 3.0 mm or more and 50 mm or less, and particularly preferably 4.0 mm or more and 30 mm or less. As a result, even a thin rigid plate 28 can have improved strength, making it easier to apply force to the wiring layer 26, which results in more efficient release of the carrier 12. Note that the width of the rigid plate 28 may be the same as the length of the long portion (that is, the rigid plate 28 may be square in shape).

The thickness of the rigid plate 28 is preferably 0.040 mm or more and 10 mm or less, more preferably 0.060 mm or more and 8.0 mm or less, further preferably 0.080 mm or more and 5.0 mm or less, and particularly preferably 0.20 mm or more and 3.0 mm or less. Such a thin rigid plate 28 makes it easier to release the wiring layer 26 from the carrier 12 at a desirable release angle, and can more effectively suppress cracking and destruction caused by inflection of the wiring layer 26.

The rigid plate 28 is preferably composed of a resin from the point that it is easy to provide the desired rigidity, Rockwell hardness, and rupture strength. Examples of such a resin include polyethylene terephthalate (PET), ultra high molecular weight polyethylene, rigid polyethylene (HPE), polypropylene (PP), polystyrene (PS), methacrylate (MA), acrylonitrile-butadiene-styrene (ABS), polyamide (nylon 6, 6N), monomer cast nylon (MC), polyacetal (POM), polycarbonate (PC), polytetrafluoroethylene (PTFE), rigid polyvinyl chloride (PVC), polyphenylene oxide (PPO), and polyurethane (PUR). In particular, the rigid plate 28 is preferably composed of at least one selected from the group consisting of polyethylene terephthalate (PET), ultra high molecular weight polyethylene (UHMW), rigid polyethylene (HPE), polypropylene (PP), and polystyrene (PS), and is more preferably composed of polyethylene terephthalate (PET). The elastic modulus of the resin constituting the rigid plate 28 is preferably 4 × 10³ kgf/cm² or more and 70 × 10³ kgf/cm² or less, more preferably 10 × 10³ kgf/cm² or more and 40 × 10³ kgf/cm² or less, and further preferably 25 × 10³ kgf/cm² or more and 35 × 10³ kgf/cm² or less. This makes it easier to apply force to the wiring layer 26 when inserting the rigid plate 28 into the laminated sheet 10 and moving it, making it easier to develop the release of the wiring layer 26 from the carrier 12 and also more effectively suppress the damage of the wiring layer 26 caused by contact with the rigid plate 28. Note that the elastic modulus in the present invention is a value measured in accordance with JIS K6911-1995.

The insertion of the rigid plate 28 into the release starting portion S is preferably performed without attaching any liquid (for example, chemical solution such as lubricant) to the rigid plate 28. By doing so, it is possible to prevent the liquid from being attached to and reacting with the metallic part of the wiring layer 26, and to avoid interfering with the metal etching that may be performed in the subsequent step.

### (4) Movement of Rigid Plate

The rigid plate 28 is moved from the release starting portion S along the release layer 16 (see Figure 3A(iv) and Figure 3B(iv)). This develops the release of the wiring layer 26 from the carrier 12. That is, when the rigid plate 28 inserted into the release starting portion S moves in a direction generally parallel to the main surface of the carrier 12, force in the direction of being pulled apart from the carrier 12 (release force) is applied to the wiring layer 26. This causes the step or gap between the wiring layer 26 and the carrier 12 to expand sequentially, resulting in progression of the release of the carrier 12. As described above, a wiring substrate can be manufactured by forming, in the laminated sheet 10 including the carrier 12, the release layer 16, and the wiring layer 26 with a predetermined flexural modulus in order, the release starting portion S between the wiring layer 26 and the carrier 12, inserting the predetermined rigid plate 28 into the release starting portion S, and then moving the rigid plate 28 along the release layer 16, thus easily and reliably releasing the carrier 12.

In this point, the conventional methods for manufacturing a wiring substrate as disclosed in Patent Literature 5 (WO2017/075151) and Patent Literature 6 (JP2015-145306A) were not sufficient from the viewpoint of easy and reliable release of the carrier. Here, Figure 5 shows an example of a conventional method for releasing a carrier, using a wire. In the conventional example shown in Figure 5, in a laminated sheet 110 including a carrier 112 and a wiring layer 126, a wire W is inserted between the carrier 112 and the wiring layer 126 to develop release of the two. In this point, the shorter the distance between the release position (fulcrum) and the position of the wire W (effort), the greater force is applied to the wiring layer 126 and the easier it is for the release to be developed. However, since the wire W easily warps in the development direction of release, force greater than that required for the release is applied to the surface of the wiring layer 126, and the wiring layer 126 may be scratched or destroyed. Also, if the wire W has insufficient strength and is ruptured, the release step is interrupted. On the other hand, even if the wire is changed to a wire W' with a larger cross-sectional diameter in order to increase the strength of the wire, the risk of the wiring layer 126 being cracked increases due to large inflection of the wiring layer 126. In particular, this problem becomes more pronounced when the wiring layer 126 includes a thin resin-containing layer with high flexural modulus (for example, resin-containing layer including a filler).

On the other hand, in the conventional method for releasing a carrier, using a knife or the like, the knife may scratch the carrier or the metal layer that may be included in the wiring layer when developing the release, leading to a problem such as manufacture of products that cannot be used as wiring substrates, resulting in decreased yield rate. In addition, if a knife or the like to which a chemical solution or the like is attached is used, the metal constituting the wiring layer reacts with the attached chemical solution, which interferes with the metal etching performed in the subsequent step.

In contrast, the present invention uses the rigid plate 28 having a long portion for the development of release, and thus large force can be applied to the wiring layer 26 without causing the rigid plate 28 itself to be ruptured. Also, even if the rigid plate 28 is thin, the strength can be increased by increasing the width of the rigid plate 28, and hence the release of the carrier 12 can be performed while suppressing inflection of the wiring layer 26. Furthermore, the present invention does not require the use of a liquid such as lubricant to perform the release of the carrier 12 without scratching the wiring layer 26, thus making it unnecessary to perform a removal operation for the lubricant or the like in the subsequent step, etching treatment step. Accordingly, the step of developing release is preferably performed without attaching any liquid to the step or gap formed in the laminated sheet 10.

The movement of the rigid plate 28 may be performed manually, or it may be performed automatically with a machine or the like. In any case, the movement of the rigid plate 28 is preferably performed while gripping (by hands, machine, or other means) near both ends of the long portion in the rigid plate 28. By doing so, it is easier to apply uniform force to the wiring layer 26 without the rigid plate 28 warping, and the release of the carrier 12 can be performed more efficiently. Also, the movement of the rigid plate 28 is preferably performed with the surface of the laminated sheet 10 on the carrier side fixed.

### (5) Release of Carrier (Optional Step)

Optionally, a step of releasing the carrier 12 from the laminated sheet 10 may be further included (see Figure 3A(v) and Figure 3B(v)). For example, by continuing the movement of the rigid plate 28 described above to the end portion on the opposite side to the release starting portion S of the laminated sheet 10, the wiring layer 26 and the carrier 12 can be completely separated. Alternatively, after developing the release of the wiring layer 26 from the carrier 12 to some extent by the movement of the rigid plate 28, the wiring layer 26 may be released from the carrier 12 by applying force to the laminated sheet 10 in a direction where the carrier 12 and the wiring layer 26 are separated.

When the wiring layer 26 includes the metal layer 18, the exposed metal layer 18 may be etched away after the release of the carrier 12. Thus, the wiring (buried wiring) formed on the surface of the metal layer 18 is exposed, which is more suitable for forming a further circuit thereon by a photolithography process. The etching of the metal layer 18 should be performed based on a known method and is not particularly limited.

### Carrier-Attached Metal Foil

As described above with reference to Figure 1, the carrier-attached metal foil, which is optionally used in the method of the present invention, includes the carrier 12, optionally the intermediate layer 14, the release layer 16, and the metal layer 18 in order.

The carrier 12 may be composed of any one of glass, ceramic, silicon, resin, and metal, but is preferably a substrate containing silicon or a glass substrate. The substrate containing silicon may be any substrate as long as the substrate contains Si as an element, and a SiO₂ substrate, a SiN substrate, a Si single crystal substrate, a Si polycrystalline substrate, or the like can be applied. A glass carrier, a single-crystal silicon substrate, or a polycrystalline silicon substrate is more preferred. According to a preferred aspect of the present invention, the carrier 12 has a disk shape with a diameter of 100 mm or more, and more preferably a disk shape with a diameter of 200 mm or more and 450 mm or less. According to another preferred aspect of the present invention, the carrier 12 has a rectangular shape with a short side of 100 mm or more, and more preferably a short side of 150 mm or more and 650 mm or less. The rectangular carrier 12 may have a roll shape with its long side sufficiently longer than its short side, and preferably has a long side of 200 mm or more and 650 mm or less.

The form of the carrier 12 may be any one of a sheet, a film, and a plate. The carrier 12 may be a laminate of these sheets, films, plates, and the like. For example, the carrier 12 may be one that can function as a support having rigidity, such as a glass plate, a ceramic plate, a silicon wafer, or a metal plate, or may be in the form of having no rigidity, such as a metal foil or a resin film. Preferred examples of the metal constituting the carrier 12 include copper, titanium, nickel, stainless steel, and aluminum. Preferred examples of the ceramic include alumina, zirconia, silicon nitride, aluminum nitride, and various other fine ceramics. Preferred examples of the resin include polyethylene terephthalate (PET), polyethylene naphthalate (PEN), polyamides, polyimides, nylons, liquid crystal polymers, polyetheretherketone (PEEK (^{®})), polyamide-imides, polyethersulfone, polyphenylene sulfide, polytetrafluoroethylene (PTFE), and ethylene tetrafluoroethylene (ETFE). More preferably, from the viewpoint of preventing the warpage of a coreless support accompanying heating at the time of mounting a semiconductor device, a material having a coefficient of thermal expansion (CTE) of less than 25 ppm/K (typically 1.0 ppm/K or more and 23 ppm/K or less) is used. Examples of such a material include various resins (particularly low thermal expansion resins such as polyimides and liquid crystal polymers), glass, silicon, and ceramic as described above. From the viewpoint of handleability and ensuring flatness during chip mounting, the carrier 12 preferably has a Vickers hardness of 100 HV or more, and more preferably 150 HV or more and 2500 HV or less. As a material satisfying these characteristics, the carrier 12 is preferably composed of glass, silicon, or ceramic, more preferably glass or ceramic, and particularly preferably glass. Examples of the carrier 12 composed of glass include a glass plate. When glass is used as the carrier 12, the advantages are that it is lightweight, has a low coefficient of thermal expansion, has high insulating properties, and is rigid and has a flat surface to enable the surface of the metal layer 18 to be extremely smoothed. In addition, when the carrier 12 is glass, the advantages are that it has surface flatness (coplanarity) advantageous for fine circuit formation, and that it has chemical resistance in desmear and various plating steps in a wiring manufacturing process. Preferred examples of the glass constituting the carrier 12 include quartz glass, borosilicate glass, alkali-free glass, soda lime glass, aluminosilicate glass, and combinations thereof, more preferably alkali-free glass, soda lime glass, and combinations thereof, and particularly preferably alkali-free glass. The alkali-free glass is glass containing substantially no alkali metals that is mainly composed of silicon dioxide, aluminum oxide, boron oxide, and alkaline earth metal oxides such as calcium oxide and barium oxide as main components and further contains boric acid. This alkali-free glass has an advantage of having a low and stable coefficient of thermal expansion in the range of 3 ppm/K or more and 5 ppm/K or less in a wide temperature zone of 0°C to 350°C, thus enabling the warpage of the glass in a process involving heating to be minimized. The thickness of the carrier 12 is preferably 100 µm or more and 2000 µm or less, more preferably 300 µm or more and 1800 µm or less, and further preferably 400 µm or more and 1100 µm or less. When the carrier 12 has a thickness within such a range, it is possible to achieve the thinning of wiring and the reduction in warpage that occurs during electronic component mounting, while ensuring suitable strength that does not hinder handling.

The optionally provided intermediate layer 14 may have a one-layer configuration or a configuration of two or more layers. When the intermediate layer 14 is composed of two or more layers, the intermediate layer 14 includes a first intermediate layer provided directly on the carrier 12, and a second intermediate layer provided adjacent to the release layer 16. The first intermediate layer is preferably a layer composed of at least one metal selected from the group consisting of Ti, Cr, Al, and Ni from the viewpoint of ensuring adhesion to the carrier 12. The first intermediate layer may be a pure metal or an alloy. The thickness of the first intermediate layer is preferably 5 nm or more and 500 nm or less, more preferably 10 nm or more and 300 nm or less, further preferably 18 nm or more and 200 nm or less, and particularly preferably 20 nm or more and 100 nm or less. The second intermediate layer is preferably a layer composed of Cu, in terms of controlling the release strength between the second intermediate layer and the release layer 16 to the desired value. The thickness of the second intermediate layer is preferably 5 nm or more and 500 nm or less, more preferably 10 nm or more and 400 nm or less, further preferably 15 nm or more and 300 nm or less, and particularly preferably 20 nm or more and 200 nm or less. Another interposed layer may be present between the first intermediate layer and the second intermediate layer, and examples of the constituent material of the interposed layer include alloys of at least one metal selected from the group consisting of Ti, Cr, Mo, Mn, W, and Ni, and Cu. On the other hand, when the intermediate layer 14 has a one-layer configuration, the first intermediate layer described above may be adopted as it is as the intermediate layer, or the first intermediate layer and the second intermediate layer may be replaced by one intermediate alloy layer. This intermediate alloy layer is preferably composed of a copper alloy in which the content of at least one metal selected from the group consisting of Ti, Cr, Mo, Mn, W, Al, and Ni is 1.0 at% or more, and the Cu content is 30 at% or more. The thickness of the intermediate alloy layer is preferably 5 nm or more and 500 nm or less, more preferably 10 nm or more and 400 nm or less, further preferably 15 nm or more and 300 nm or less, and particularly preferably 20 nm or more and 200 nm or less. Note that the thickness of each layer described above is a value measured by analyzing a layer cross section by a transmission electron microscope-energy dispersive X-ray spectrometer (TEM-EDX). The metal constituting the intermediate layer 14 may contain unavoidable impurities resulting from the raw material component, the film formation step, and the like. In the case of exposure to the air after the film formation of the intermediate layer 14, the presence of oxygen mixed due to the exposure is allowed. The intermediate layer 14 may be manufactured by any method, but is particularly preferably a layer formed by a magnetron sputtering method using a metal target because the layer allows for the uniformity of film thickness distribution.

The release layer 16 is a layer that enables or facilitates the release of the carrier 12 and, when present, the intermediate layer 14. The release layer 16 may be a layer that can be released using a laser release method (laser lift-off, LLO) in addition to a layer that can be released using a method of physically applying a force. When the release layer 16 is composed of a material that can be released by laser lift-off, the release layer 16 may be composed of a resin with its adhesive strength at the interface reduced by laser beam irradiation after curing, or may be a layer of silicon, silicon carbide, metal oxide, or the like that is modified by laser beam irradiation. The release layer 16 may be either an organic release layer or an inorganic release layer. Examples of the organic component used for the organic release layer include nitrogen-containing organic compounds, sulfur-containing organic compounds, and carboxylic acids. Examples of the nitrogen-containing organic compounds include triazole compounds and imidazole compounds. On the other hand, examples of the inorganic component used for the inorganic release layer include metal oxides or metal oxynitrides including at least one or more of Cu, Ti, Al, Nb, Zr, Cr, W, Ta, Co, Ag, Ni, In, Sn, Zn, Ga, and Mo, or carbon. Among these, the release layer 16 is preferably a layer mainly containing carbon, in terms of ease of release, layer formation properties, and the like, more preferably a layer mainly composed of carbon or a hydrocarbon, and further preferably a layer composed of amorphous carbon, a hard carbon film. In this case, the release layer 16 (that is, a carbon-containing layer) preferably has a carbon concentration of 60 atomic% or more, more preferably 70 atomic% or more, further preferably 80 atomic% or more, and particularly preferably 85 atomic% or more as measured by x-ray photoelectron spectroscopy (XPS). The upper limit value of the carbon concentration is not particularly limited and may be 100 atomic% but is practically 98 atomic% or less. The release layer 16 can contain unavoidable impurities (for example, oxygen, carbon, and hydrogen, which are derived from the surrounding environment such as the atmosphere). In the release layer 16, atoms of metals of types other than the metal contained as the release layer 16 can be mixed due to the film formation method of the metal layer 18 or the like to be laminated later. When a carbon-containing layer is used as the release layer 16, the interdiffusivity and reactivity with the carrier are low, and even if the layer is subjected to pressing at a temperature exceeding 300°C, mutual diffusion of metal elements due to high-temperature heating between the metal layer and the bonding interface can be prevented to maintain a state where the release and removal of the carrier is easy. The release layer 16 is preferably a layer formed by a vapor phase method such as sputtering, in terms of inhibiting excessive impurities in the release layer 16, achieving the continuous productivity of other layers, and other respects. The thickness when a carbon-containing layer is used as the release layer 16 is preferably 1 nm or more and 20 nm or less, and more preferably 1 nm or more and 10 nm or less. This thickness is a value measured by analyzing a layer cross section by a transmission electron microscope-energy dispersive X-ray spectrometer (TEM-EDX).

The release layer 16 may be a layer including either or both a metal oxide layer or a carbon-containing layer, or a layer including both a metal oxide and carbon. Particularly, when the carrier-attached metal foil includes the intermediate layer 14, the carbon-containing layer can contribute to the stable release of the carrier 12, and the metal oxide layer can more effectively inhibit the diffusion of the metal elements derived from the intermediate layer 14 and the metal layer 18, accompanying heating. As a result, even after the heating at a temperature as high as, for example, 350°C or more, stable releasability can be maintained. The metal oxide layer is preferably a layer including an oxide of metals composed of Cu, Ti, Al, Nb, Zr, Cr, W, Ta, Co, Ag, Ni, In, Sn, Zn, Ga, Mo, and combinations thereof. The metal oxide layer is particularly preferably a layer formed by a reactive sputtering method in which sputtering is performed under an oxidizing atmosphere, using a metal target, in terms of being able to easily control film thickness by the adjustment of film formation time. The thickness of the metal oxide layer is preferably 0.1 nm or more and 100 nm or less. The upper limit value of the thickness of the metal oxide layer is more preferably 60 nm or less, further preferably 30 nm or less, and particularly preferably 10 nm or less. This thickness is a value measured by analyzing a layer cross section by a transmission electron microscope-energy dispersive X-ray spectrometer (TEM-EDX). At this time, the order in which the metal oxide layer and the carbon layer are laminated as the release layer 16 is not particularly limited. The release layer 16 may be present in a state of a mixed phase in which the boundary between the metal oxide layer and the carbon-containing layer is not clearly identified (that is, a layer containing both metal oxide and carbon).

Similarly, from the viewpoint of maintaining stable releasability even after heat treatment at high temperatures, the release layer 16 may be a metal-containing layer in which the surface on the side adjacent to the metal layer 18 is a fluorination-treated surface and/or a nitriding-treated surface. In the metal-containing layer, a region in which the sum of the content of fluorine and the content of nitrogen is 1.0 atomic% or more (hereinafter referred to as a "(F + N) region") is preferably present over a thickness of 10 nm or more, and the (F + N) region is preferably present on the metal layer 18 side of the metal-containing layer. The thickness (in terms of SiO₂) of the (F + N) region is a value specified by performing the depth profile elemental analysis of the carrier-attached metal foil using XPS. The fluorination-treated surface or the nitriding-treated surface can be preferably formed by reactive ion etching (RIE) or a reactive sputtering method. On the other hand, the metal element included in the metal-containing layer preferably has a negative standard electrode potential. Preferred examples of the metal element included in the metal-containing layer include Cu, Ag, Sn, Zn, Ti, Al, Nb, Zr, W, Ta, Mo, and combinations thereof (for example, alloys and intermetallic compounds). The content of the metal element in the metal-containing layer is preferably 50 atomic% or more and 100 atomic% or less. The metal-containing layer may be a single layer composed of one layer or a multilayer composed of two or more layers. The thickness of the entire metal-containing layer is preferably 10 nm or more and 1000 nm or less, more preferably 30 nm or more and 500 nm or less, further preferably 50 nm or more and 400 nm or less, and particularly preferably 100 nm or more and 300 nm or less. The thickness of the metal-containing layer itself is a value measured by analyzing a layer cross section by a transmission electron microscope-energy dispersive X-ray spectrometer (TEM-EDX).

Alternatively, the release layer 16 may be a metal oxynitride-containing layer instead of a carbon layer or the like. The surface of the metal oxynitride-containing layer opposite to the carrier 12 (that is, on the metal layer 18 side) preferably includes at least one metal oxynitride selected from the group consisting of TaON, NiON, TiON, NiWON, and MoON. In terms of ensuring the adhesion between the carrier 12 and the metal layer 18, the surface of the metal oxynitride-containing layer on the carrier 12 side preferably includes at least one selected from the group consisting of Cu, Ti, Ta, Cr, Ni, Al, Mo, Zn, W, TiN, and TaN. Thus, the number of foreign matter particles on the surface of the metal layer 18 is suppressed to improve circuit formation properties, and even after heating at high temperatures for a long time, stable release strength can be maintained. The thickness of the metal oxynitride-containing layer is preferably 5 nm or more and 500 nm or less, more preferably 10 nm or more and 400 nm or less, further preferably 20 nm or more and 200 nm or less, and particularly preferably 30 nm or more and 100 nm or less. This thickness is a value measured by analyzing a layer cross section by a transmission electron microscope-energy dispersive X-ray spectrometer (TEM-EDX).

The metal layer 18 is a layer composed of metal. The metal layer 18 may have a one-layer configuration or a configuration of two or more layers. When the metal layer 18 is composed of two or more layers, the metal layer 18 can have a configuration in which metal layers from a first metal layer to an m-th metal layer (m is an integer of 2 or more) are laminated in order on the surface side of the release layer 16 opposite to the carrier 12. The thickness of the entire metal layer 18 is preferably 1 nm or more and 2000 nm or less, preferably 100 nm or more and 1500 nm or less, more preferably 200 nm or more and 1000 nm or less, further preferably 300 nm or more and 800 nm or less, and particularly preferably 350 nm or more and 500 nm or less. The thickness of the metal layer 18 is a value measured by analyzing a layer cross section by a transmission electron microscope-energy dispersive X-ray spectrometer (TEM-EDX). An example in which the metal layer 18 is composed of two layers, a first metal layer and a second metal layer, will be described below.

The first metal layer preferably provides the desired functions such as an etching stopper function and an antireflection function to the carrier-attached metal foil. Preferred examples of the metal constituting the first metal layer include Ti, Al, Nb, Zr, Cr, W, Ta, Co, Ag, Ni, Mo, and combinations thereof, more preferably Ti, Zr, Al, Cr, W, Ni, Mo, and combinations thereof, further preferably Ti, Al, Cr, Ni, Mo, and combinations thereof, and particularly preferably Ti, Mo, and combinations thereof. These elements have the property of being less likely to dissolve in flash etchants (for example, copper flash etchants) and, as a result, can exhibit excellent chemical resistance to flash etchants. Therefore, the first metal layer is a layer less likely to be etched with a flash etchant than the second metal layer to be described later, and can thus function as an etching stopper layer capable of delaying progression of etching. In addition, the metal constituting the first metal layer described above also has the function of preventing the reflection of light, and hence the first metal layer can also function as an antireflection layer for improving visibility in image inspection (for example, automatic image inspection (AOI)). The first metal layer may be a pure metal or an alloy. The metal constituting the first metal layer may contain unavoidable impurities resulting from the raw material component, the film formation step, and the like. The upper limit of the content of the metal is not particularly limited and may be 100 atomic%. The first metal layer is preferably a layer formed by a physical vapor deposition (PVD) method, and more preferably a layer formed by sputtering. The thickness of the first metal layer is preferably 1 nm or more and 500 nm or less, more preferably 10 nm or more and 400 nm or less, further preferably 30 nm or more and 300 nm or less, and particularly preferably 50 nm or more and 200 nm or less.

Preferred examples of the metal constituting the second metal layer include the transition elements of groups 4, 5, 6, 9, 10, and 11, Al, and combinations thereof (for example, alloys and intermetallic compounds), more preferably the transition elements of groups 4 and 11, Al, Nb, Co, Ni, Mo, and combinations thereof, further preferably the transition elements of group 11, Ti, Al, Mo, and combinations thereof, particularly preferably Cu, Ti, Mo, and combinations thereof, and most preferably Cu. The second metal layer may be manufactured by any method and may be a metal foil formed by, for example, wet film formation methods such as an electroless metal plating method and an electrolytic metal plating method, physical vapor deposition (PVD) methods such as sputtering and vacuum deposition, chemical vapor film formation, or combinations thereof. A particularly preferred second metal layer is a metal layer formed by physical vapor deposition (PVD) methods such as a sputtering method and vacuum deposition, most preferably a metal layer manufactured by a sputtering method, from the viewpoint of being easily adapted to a fine pitch due to superthinning. The second metal layer is preferably a metal layer without roughening treatment, but may be one in which secondary roughening is performed by preliminary roughening, soft etching treatment, rinse treatment, or oxidation-reduction treatment, as long as wiring pattern formation is not hindered. From the viewpoint of being adapted to a fine pitch, the thickness of the second metal layer is preferably 10 nm or more and 1000 nm or less, more preferably 20 nm or more and 900 nm or less, further preferably 30 nm or more and 700 nm or less, further more preferably 50 nm or more and 600 nm or less, particularly preferably 70 nm or more and 500 nm or less, and most preferably 100 nm or more and 400 nm or less. The metal layer having a thickness within such a range is preferably manufactured by a sputtering method from the viewpoint of the in-plane uniformity of film formation thickness, and productivity in a sheet form or a roll form.

When the metal layer 18 has a one-layer configuration, the second metal layer described above is preferably adopted as it is as the metal layer 18. On the other hand, when the metal layer 18 has an n-layer (n is an integer of 3 or more) configuration, the metal layers from the first to the (n-1)th in the metal layer 18 preferably have the configuration of the first metal layer described above, and the outermost layer, that is, the n-th metal layer, in the metal layer 18 preferably has the configuration of the second metal layer described above.

The end face of the carrier 12 is preferably covered by the extension of the metal layer 18, optionally the intermediate layer 14, and optionally the release layer 16 (that is, at least the metal layer 18, for example, the metal layer 18 and the intermediate layer 14) to the end face. That is, not only the surface but also the end face of the carrier 12 is preferably covered with at least the metal layer 18. By covering the end face as well, it is possible to prevent the infiltration of chemical liquids into the carrier 12 in the wiring substrate manufacturing process, and also to strongly prevent chipping due to release at the side end when the carrier-attached metal foil or the laminated sheet 10 is handled, that is, chipping of the film on the release layer 16 (that is, the metal layer 18). The covered region on the end face of the carrier 12 is preferably a region 0.1 mm or more and more preferably 0.2 mm or more from the surface of the carrier 12 toward the thickness direction (that is, the direction perpendicular to the carrier surface), and is further preferably throughout the end face of the carrier 12.

### EXAMPLES

The present invention will be further described by the following examples.

### Example 1

By the method of the present invention, preparation of the laminated sheet and release of the carrier were performed as follows.

### (1) Preparation of Laminated Sheet

A glass substrate (material: soda-lime glass) with a size of 98 mm x 68 mm and a thickness of 1.1 mm was provided as the carrier 12. On the carrier 12, a titanium layer (thickness 50 nm) and a copper layer (thickness 200 nm) as the intermediate layer 14 having a two-layer configuration, an amorphous carbon layer (thickness 6 nm) as the release layer 16, and a titanium layer (thickness 100 nm) and a copper layer (thickness 300 nm) as the metal layer 18 having a two-layer configuration were deposited by sputtering in this order to obtain the carrier-attached metal foil. At this time, the metal layer 18 was deposited so as to extend out to the end faces of the carrier 12, thereby covering the end portions of the release layer 16.

On the metal layer 18 of the carrier-attached metal foil, the redistribution layer 20 with a size of 98 mm × 68 mm and a thickness of 20 µm was formed. Specifically, first, a photosensitive dry film was adhered to the surface of the carrier-attached metal foil on the metal layer 18 side, and then exposed and developed to form a photoresist layer with a predetermined pattern. Next, pattern electrolytic copper plating was performed on the exposed surface of the metal layer 18 (that is, the part not masked by the photoresist layer) to form an electrolytic copper plating layer, and then the photoresist layer was stripped. By doing so, the metal layer 18 and the electrolytic copper plating layer were left in the form of a wiring pattern, while the metal layer 18 in the part where these wiring patterns were not formed was exposed. Thereafter, unnecessary part of the exposed metal layer 18 was removed with an etchant to form the wiring layer. Furthermore, an insulating resin material (photosensitive insulating material, AR-5100 manufactured by Showa Denko Materials Co., Ltd.) was laminated on the wiring layer side of the carrier-attached metal foil and subjected to a heat curing treatment at 230°C for 60 minutes, thereby forming an insulating layer. In this way, the redistribution layer 20 including the wiring layer and the insulating layer was formed.

An epoxy-containing resin including a SiO₂ filler (flexural strength and flexural modulus are as shown in Table 1) was applied on the redistribution layer 20 to form the resin-containing layer 24 with a size of 90 mm × 60 mm and a thickness of 0.2 mm. This epoxy-containing resin was obtained by mixing a liquid bisphenol F epoxy resin and a phenol biphenyl aralkyl resin (curing agent) in a molar ratio of epoxy groups/phenolic hydroxy groups = 1.0, and blending 86 parts by weight of the SiO₂ filler to 14 parts by weight of the obtained resin mixture. Thus, a laminated sheet 10 provided with the carrier 12, the intermediate layer 14, the release layer 16, the metal layer 18 as the wiring layer 26, the redistribution layer 20, and the resin-containing layer 24 in this order was prepared. The release strength when separating the laminated sheet 10 into the carrier 12 and the wiring layer 26 at the release layer 16 was 6.5 gf/cm.

### (2) Formation of Release Starting Portion

The surface of the laminated sheet 10 on the carrier 12 side was fixed to a workbench with commercially available double-sided tape. Next, a cut was formed by inserting the blade of a cutter (material: tungsten) in a direction generally perpendicular to the main surface of the carrier 12 from the surface of the metal layer 18 of the laminated sheet 10. The cut was formed in a rectangular pattern (four-sided linear pattern) to surround the resin-containing layer 24 when the laminated sheet 10 was seen in a planar view. The cut was made to be deep enough to penetrate the metal layer 18, the release layer 16, and the intermediate layer 14, but not to penetrate the carrier 12 when the laminated sheet 10 was seen in a cross-sectional view. The laminated sheet 10 was thus trimmed, and the sections in the metal layer 18 that covered the end portions of the release layer 16 were removed. Then, at one end (corner part) of the laminated sheet 10, a cutter was inserted near the exposed release layer 16 to form a gap, which was used as the release starting portion S.

### (3) Insertion of Rigid Plate

A long PET film (flexural modulus: 3.1 GPa, flexural strength: 130 MPa, Rockwell hardness: R125, rupture strength: 6.3 kgf, elastic modulus: 30.7 × 10³ kgf/cm²) with a size of 10 mm × 150 mm and a thickness of 0.073 mm was used as the rigid plate 28, and inserted from the long portion of the PET film to the release starting portion S formed in the laminated sheet 10. At this time, the insertion angle of the rigid plate 28 was 0° (parallel to the main surface of the carrier 12).

### (4) Movement of Rigid Plate

The rigid plate 28 was moved from the release starting portion S along the release layer 16 while gripping by hands near both ends of the long portion in the rigid plate 28. By continuing the movement of the rigid plate 28 to the end portion on the opposite side to the release starting portion S of the laminated sheet 10, the wiring layer 26 and the carrier 12 were completely separated. Note that no liquid such as lubricant was used in each of the steps of forming the release starting portion, and inserting and moving the rigid plate.

### Example 2 (comparative)

Preparation of the laminated sheet and release of the carrier were performed in the same manner as in Example 1, except that a wire with a cross-sectional diameter of about 0.23 mm (manufactured by Nippon Chuko Co., Ltd., Super Nylon Thread, product number: A10-13, material: nylon, flexural modulus: 11 GPa, Rockwell hardness: R120, rupture strength: 0.41 kgf) was used instead of the PET film as the rigid plate 28, inserted into the release starting portion, and moved.

### Examples 3 to 12

Preparation of the laminated sheet and release of the carrier were performed in the same manner as in Example 1, except that the thickness of the resin-containing layer 24, and/or the characteristics of the epoxy resin constituting the resin-containing layer 24 (filler content, flexural strength, and flexural modulus) were changed in the preparation of the laminated sheet, as shown in Table 1.

### Evaluation

Various evaluations were performed on the laminated sheet after releasing the carrier, as shown below.

### (a) Checking for Cracks and Scratches

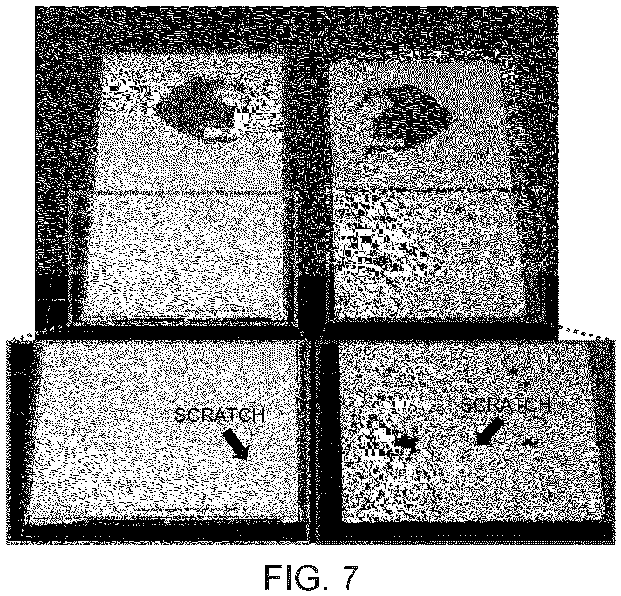

For the wiring layer 26 after releasing the carrier 12, the presence or absence of cracks was visually checked. As a result, no cracks were observed in the wiring layer 26 in any of Examples 1 to 12. Also, the presence or absence of scratches on the release face of the laminated sheet 10, that is, the copper layer side surface of the intermediate layer 14 and the titanium layer side surface of the metal layer 18, was visually observed. As a result, the occurrence of scratches on the release face of the laminated sheet 10 was not observed for Examples 1 and 3 to 12. On the other hand, for Example 2 (comparative), scratches were observed on both the copper layer side surface of the intermediate layer 14 and the titanium layer side surface of the metal layer 18. For reference, photographs in which the copper layer of the intermediate layer 14 and the titanium layer of the metal layer 18 after release in Examples 1 and 2 were taken are shown in Figures 6 and 7, respectively.

### (b) Discoloration after Etching

For the titanium layer side surface of the metal layer 18 (release face of the wiring layer 26), metal etching was carried out using a titanium etchant (manufactured by Meltex Inc., Melstrip TI-3991) for 150 seconds. Thereafter, the surface of the wiring layer 26 on the side where metal etching was performed was visually observed to check for the presence or absence of discoloration (occurrence of speckled patterns due to shades of color). As a result, no discoloration was observed in the wiring layer 26 in any of Examples 1 to 12.

### [Table 1]

**Table 1**

| | | Ex. 1 | Ex. 2* | Ex. 3 | Ex. 4 | Ex. 5 | Ex. 6 | Ex. 7 | Ex. 8 | Ex. 9 | Ex. 10 | Ex. 11 | Ex. 12 |
|---|---|---|---|---|---|---|---|---|---|---|---|---|---|
| Wiring layer (resin-containing layer) | Filler content (wt%) | 86 | 86 | 86 | 89 | 90 | 90 | 86 | 86 | 89 | 90 | 90 | 86 |
| | Thickness (mm) | 0.2 | 0.2 | 0.9 | 0.9 | 0.9 | 0.9 | 0.9 | 0.6 | 0.6 | 0.6 | 0.6 | 0.6 |
| | Flexural strength (MPa) | 150 | 150 | 150 | 170 | 169 | 75 | 150 | 150 | 170 | 169 | 75 | 150 |
| | Flexural modulus (GPa) | 22.0 | 22.0 | 22.0 | 20.4 | 24.4 | 12.0 | 23.0 | 22.0 | 20.4 | 24.4 | 12.0 | 23.0 |
| Evaluation | Occurrence of scratches | Absent | Present | Absent | Absent | Absent | Absent | Absent | Absent | Absent | Absent | Absent | Absent |

| | | | | | | | | | | | | | |
|---|---|---|---|---|---|---|---|---|---|---|---|---|---|
| * indicates Comparative Example. | | | | | | | | | | | | | |

## Claims

1. A method for manufacturing a wiring substrate, comprising the steps of:
providing a laminated sheet that includes a release layer and a wiring layer in order on a carrier;
forming a step or gap between the wiring layer and the carrier as a release starting portion;
inserting a rigid plate having a long portion into the release starting portion from the long portion, wherein the long portion is longer than a width of the laminated sheet; and
moving the rigid plate from the release starting portion along the release layer, thereby developing release of the wiring layer from the carrier,
wherein the wiring layer has a flexural modulus at 25°C measured in accordance with JIS K6911-1995 of 0.3 GPa or more and 300 GPa or less.

2. The method for manufacturing the wiring substrate according to claim 1, wherein the wiring layer has a flexural strength at 25°C measured in accordance with JIS K6911-1995 of 5 MPa or more and 1000 MPa or less.

3. The method for manufacturing the wiring substrate according to claim 1 or 2, wherein the rigid plate has a Rockwell hardness at 25°C measured in accordance with JIS Z2245:2016 of R135 or less.

4. The method for manufacturing the wiring substrate according to claim 1 or 2, wherein the rigid plate has a rupture strength at 25°C measured in accordance with JIS K7161-1:2014 of 0.50 kgf or more.

5. The method for manufacturing the wiring substrate according to claim 1 or 2, wherein a release strength when releasing the wiring layer from the carrier is 0.10 gf/cm or more and 50 gf/cm or less.

6. The method for manufacturing the wiring substrate according to claim 1 or 2, wherein the release starting portion is formed at an end portion of the wiring layer and/or at an end portion of the carrier.

7. The method for manufacturing the wiring substrate according to claim 1 or 2, wherein an insertion angle of the rigid plate with respect to a main surface of the carrier is 0° or more and 90° or less.

8. The method for manufacturing the wiring substrate according to claim 1 or 2, wherein the rigid plate has a tip angle of 0° or more and 90° or less on a long portion side or has a curvature of a tip of 0.1 mm or more and 10 mm or less on a long portion side, when seen in a cross-sectional view.

9. The method for manufacturing the wiring substrate according to claim 1 or 2, wherein a total angle of an insertion angle of the rigid plate with respect to a main surface of the carrier and a tip angle on a long portion side of the rigid plate when the rigid plate is seen in a cross-sectional view is 0° or more and 120° or less.

10. The method for manufacturing the wiring substrate according to claim 1 or 2, wherein the rigid plate has a width of 1.0 mm or more and 300 mm or less.

11. The method for manufacturing the wiring substrate according to claim 1 or 2, wherein the rigid plate has a thickness of 0.040 mm or more and 10 mm or less.

12. The method for manufacturing the wiring substrate according to claim 1 or 2, wherein the rigid plate is composed of a resin.

13. The method for manufacturing the wiring substrate according to claim 1 or 2, wherein the step of forming the release starting portion and/or the step of developing release is performed without attaching any liquid to the step or gap.

14. The method for manufacturing the wiring substrate according to claim 1 or 2, wherein the wiring layer includes at least one selected from the group consisting of a metal layer, a semiconductor device, and a resin-containing layer.

15. The method for manufacturing the wiring substrate according to claim 14, wherein the wiring layer has a thickness of 0.1 µm or more and 5.0 mm or less.

16. The method for manufacturing the wiring substrate according to claim 14, wherein the wiring layer includes a metal layer and a resin-containing layer.

17. The method for manufacturing the wiring substrate according to claim 14, wherein the wiring layer includes a resin-containing layer, and the resin-containing layer includes a filler.

18. The method for manufacturing the wiring substrate according to claim 17, wherein the resin-containing layer has a filler content of 95% by weight or less.
